# EUROPEAN PATENT SPECIFICATION

(11) **EP 2 830 207 B1**
(45) Date of publication and mention of the grant of the patent: **27.11.2019**
(21) Application number: 14175917.5
(22) Date of filing: 07.07.2014
(51) Int. Cl.: H02M 7/49, H02M 1/00, H02P 27/06

(54) **Multilevel inverter with separately fed cell modules**
Mehrstufiger Wechselrichter mit separat eingespeisten Zellmodulen
Onduleur multi-niveaux avec modules cellulaires à alimentation séparé

(30) Priority: 22.07.2013 KR 20130085813
(43) Date of publication of application: 28.01.2015
(73) Proprietor: LSIS Co., Ltd., Anyang-si, Gyeonggi-do 431-080 (KR)
(72) Inventor: Yun, Hong Min, 431-764 Gyeonggi-do (KR)
(74) Representative: K&L Gates LLP

(56) References cited:
- EP-A2- 2 290 800
- JP-A- 2005 160 136
- US-A1- 2012 275 202

## Description

### BACKGROUND OF THE DISCLOSURE

### Field

The teachings in accordance with the exemplary embodiments of this present disclosure generally relate to a multilevel inverter.

### Background

Medium voltage high capacity multilevel inverters have emerged from development demands on medium voltage power conversion for promotion and operation of efficient and flexible power systems in electric power industries such as FACTS (Flexible AC Transmission System) devices. Recently, interests in multilevel inverters have increased as multilevel inverter topologies.

Some of the known types of configurations for multilevel inverters are cascaded H-bridge, diode-clamped and flying capacitor multi-level inverters. The cascaded H-bridge inverter is configured by unit cells having independent DC links by serially connected low voltage H-bridge inverters, where a sum of voltages of each cell equals to a sum of inverter outputs, and the output voltages may vary according to the number of cells. However, the cascaded H-bridge inverter topology suffers from disadvantage that independent DC link power must be supplied.

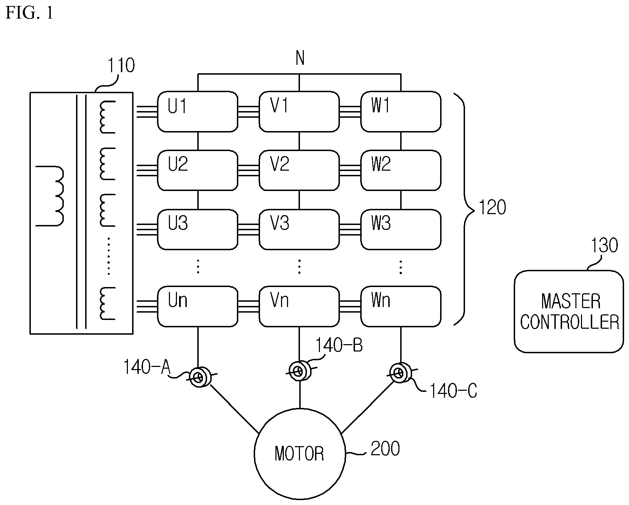

FIG. 1 is a block diagram schematically illustrating a cascaded H-bridge inverter topology according to prior art.

Referring to FIG. 1, the cascaded H-bridge inverter topology according to prior art includes a master controller (130) and a cell controller (not shown) inside a plurality of cells (120), where control is performed by the master controller (120) and the cell controller, both of which are connected to a high speed link, whereby data is transmitted and received.

The master controller (120) receives a motor speed and an output current of the inverter to perform the motor speed and current control, and transmits to the cell controller by synchronizing 3-phase voltage levels for each phase. The cell controller generates a PWM (Pulse Width Modulation) using DC link voltages of each cell (120) and voltage levels received from the master controller (120). The master controller (120) in the conventional cascaded H-bridge inverter detects, from a motor (200), a current of each phase for safe acceleration/deceleration of the motor (200) and a current sensor (140) is provided to this end.

The current sensor (140) used for the motor (200) according to prior art is a current-type current sensor instead of voltage-type current sensor due to the fact that a final insulation voltage is equal to a voltage of the motor (120) and a detection length of the current sensor (140) is very long. Furthermore, the current-type current sensor is robust to noise.

That is, selection of detection current sensor is restricted due to pre voltage and current conditions, and there is no way to cope with hardware loss as only one element for detecting the current of each phase is available.

As one of prior arts, US 2012/275202 discloses a series multiplex power conversion apparatus includes a plurality of phases. Each of the plurality of phases includes a plurality of power conversion cells coupled in series to each other. Each of the plurality of power conversion cells includes a current detector configured to detect a current through one phase among the plurality of phases corresponding to the current detector. Each of the plurality of power conversion cells is configured to independently stop a power conversion operation based on the current detected by the current detector.

As another prior art, EP 2 290 800 discloses a control device and a control method of a high voltage inverter capable of automatically and accurately setting up neutral point information at a master controller and a plurality of cell controllers of the high voltage inverter, wherein a master controller determines information of neutral point set up to itself and performs a communication with the cell controllers each disposed at each of a plurality of U phase unit cells, a plurality of V phase unit cells and a plurality of W phase unit cells to determine the neutral point information preset on the cell controllers and to detect a cell controller set up with neutral point information different from that of the master controller, and to correct the neutral point information of the detected relevant cell controller using the neutral point information set up in the master controller, thereby operating the high voltage inverter. JP-A_2005160136 (TOYOTA) can be here somehow relevant as converter.

### SUMMARY OF THE DISCLOSURE

The present disclosure is to provide a multilevel inverter configured to detect a current of the multilevel inverter using a general purpose current detection element by providing a same current to serially connected cells and detecting a current from each cell. Furthermore, the present disclosure is to provide a multilevel inverter configured to be applied with a current detection element regardless of restrictive conditions relative to voltage and current conditions and noise.

In one general aspect of the present disclosure, there is provided a multilevel inverter configured to output a 3-phase voltage to a motor, the multilevel inverter includes a plurality of serially connected unit power cells forming one phase, each of the unit power cells comprising a plurality of current sensor configured to detect an output current of said each of the unit power cells

Preferably, but not necessarily, the multilevel inverter may further comprise a master controller configured to transmit voltage level information to said each of the unit power cells by receiving an output current of said each of the plurality of unit power cells.

Preferably, but not necessarily, said each of the unit power cell may include a rectifier configured to rectify an inputted AC voltage to a DC voltage, a DC link capacitor configured to smooth an output voltage of the rectifier, a cell controller configured to generate a PWM (Pulse Width Modulation) signal in response to the voltage level information received from the master controller, an inverter unit configured to convert a DC voltage of the DC link capacitor to an AC voltage to be outputted to the motor in response to the PWM signal of the cell controller, and the current sensor configured to detect an output current of the inverter unit.

Preferably, but not necessarily, the inverter unit may include a plurality of semiconductor devices, and the current sensor may detect a current outputted from the plurality of semiconductor devices.

Preferably, but not necessarily, the current sensor may detect the output current of the inverter unit and may provide the output current to the master controller.

### Advantageous Effects of the Disclosure

The multi-level inverter system according to the present disclosure thus described has an advantageous effect in that system reliability can be enhanced by outputting a same set performance even if there is generated hardware defect when a system is formed, and maintenance cost of the system can be reduced due to no separate set change.

Another advantageous effect is that a current can be detected for each set to allow detecting a current safely relative to voltage, and a more accurate value can be detected.

### Brief Description of Drawings

FIG. 1 is a schematic block diagram illustrating a cascade H-bridge inverter according to prior art.
FIG. 2 is a schematic block diagram illustrating a multilevel inverter according to an exemplary embodiment of the present disclosure.
FIG. 3 is a detailed block diagram illustrating each cell of FIG. 2.

### Detailed Description of the Disclosure

Various exemplary embodiments will be described more fully hereinafter with reference to the accompanying drawings, in which some exemplary embodiments are shown. The present inventive concept may, however, be embodied in many different forms and should not be construed as limited to the example embodiments set forth herein. Rather, the described aspect is intended to embrace all such alterations, modifications, and variations that fall within the scope and novel idea of the present disclosure.

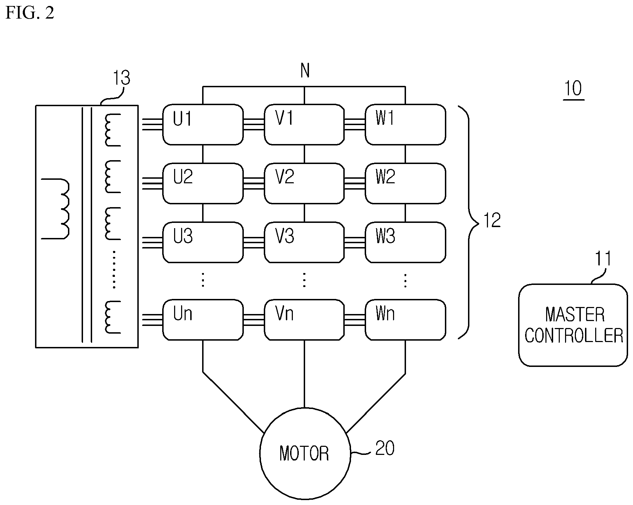

FIG. 2 is a schematic block diagram illustrating a multilevel inverter according to an exemplary embodiment of the present disclosure.

Although the multilevel inverter according to the present disclosure explains a cascaded H-bridge inverter, for example, the present disclosure is not limited thereto, and the present disclosure may be applied to other types of inverters.

Referring to FIG.2, a multilevel inverter (10) according to the present disclosure is configured to control a motor (20) and includes a master controller (11), a plurality of unit power cells (hereinafter referred to as "cells", 12) and a phase shift transformer (13).

The phase shift transformer (13) is configured to supply an independent electric power to each cell (12). The detailed explanation on configuration of the phase shift transformer will be omitted as it is not directly related to the present disclosure.

The plurality of cells (12) includes a cell (U1, U2, .....Un) forming a U phase, a cell (V1, V2, .....Vn) forming a V phase and a cell (W1, W2, .....Wn) forming a W phase, where the cells are serially connected to provide each phase, and a sum of outputs of these cells may be multilevel output voltages for driving the motor (20). The number of cells forming a cell may be determined by the output voltages.

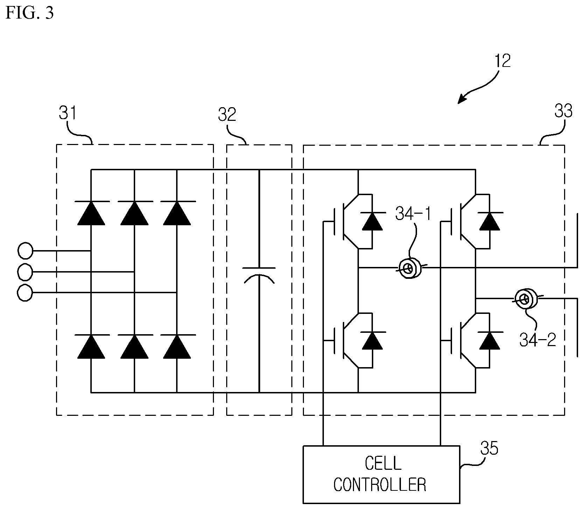

FIG. 3 is a detailed block diagram illustrating each cell of FIG. 2, where only one cell is described as each configuration of the plurality of cells is same.
Referring to FIG. 3, the unit power cell (12) according to the present disclosure includes a rectifier (31), a DC link capacitor (32), an inverter unit (33), a current sensor (34) and a cell controller (35).

The rectifier (31) rectifies an AC voltage inputted from the phase shift transformer (13) to a DC voltage, and the DC link capacitor (32) smoothes the DC voltage inputted from the rectifier (31). The rectifier (31) may be formed with a plurality of diodes.

The inverter unit (33) generates an AC voltage to be outputted to the motor (20) in response to PWM control of the cell controller (35), and outputs the AC voltage, and may be formed by a plurality of IGBTs (Insulated Gate Bipolar Transistors), for example. The current sensor (34) may detect a current outputted from the plurality of semiconductor devices of the inverter unit (33), and provide the current to the master controller (11). Although the master controller (11) of FIG.2 is illustrated as being formed independently from the plurality of cells (12), it is for the simplicity of drawing, and the master controller (11) and the cell controller (35) of the plurality of cells (12) may be connected via optical communication for insulation and reduction in noise.

The master controller (11) receives an output voltage from the plurality of cells and in turn transmits voltage level information to the cells (12). Each cell (12) may apply an output voltage corresponding to the DC link voltage to the motor (20) which is a load, generates a PWM signal in response to the voltage level information, whereby frequency applied to the motor (20) can be varied to obtain a starting torque and control a motor speed at the same time.

The multilevel inverter (10) according to the present disclosure is configured such that the current sensor (34) is arranged respectively on the plurality of cells (12) forming a phase voltage inputted to the motor (20) and detects an output current of the inverter unit (33) in the plurality of cells (12).

By the configuration thus described, each cell may use a voltage type current sensor because noise level is lower than that of the entire multilevel inverter (10), and therefore, a detection length is short and power supply is smooth because the current detection is performed by the cells (12). Furthermore, an over-current protection for each cell (12) is possible to thereby enable a build-up of reliable system.

In addition, a current flowing from each phase to the cell (12) is same, and even if one cell is inoperative, a continuous current detection is enabled, and the master controller (11) can more accurately transmit control information to the cell controller (35) because the current information of cells (12) is transmitted to the master controller (11).

Still furthermore, a general purpose voltage type current sensor can be used in comparison to a current sensor of an inverter unit to thereby reduce costs over the conventional large capacity current sensor, and because a dielectric withstanding voltage to the current sensor is limited to the cell voltage, no additional insulation reinforcement is required.

## Claims

1. A multilevel inverter (10) configured to output a 3-phase voltage to a motor (20), the multilevel inverter including
a plurality of serially connected unit power cells (12) forming one phase, **characterized in that** each of the unit power cells comprising two current sensors (34-1, 34-2) configured to detect an output current of said each of the unit power cells.
wherein said each of the unit power cells (12) includes a rectifier (31) configured to rectify an inputted AC voltage to a DC voltage, a DC link capacitor (32) configured to smooth an output voltage of the rectifier, a cell controller (35) configured to generate a PWM (Pulse Width Modulation) signal in response to the voltage level information received from the master controller (11), an inverter unit (33) configured to convert a DC voltage of the DC link capacitor (32) to an AC voltage to be outputted to the motor (20) in response to the PWM signal of the cell controller (35), and two current sensors (34-1, 34-2) configured to detect an output current of the inverter unit (33).
wherein the inverter unit (33) includes a first convert unit and a second convert unit, each of the first convert unit and the second convert unit includes two IGBTs (Insulated Gate Bipolar Transistors) connected in series, and the first convert unit and the second convert unit are connected in parallel,
wherein two current sensors (34-1, 34-2) includes a first current sensor (34-1) configured to provide a current detected from the AC voltage output of the first convert unit to the master controller (11), and a second current sensor (34-2) configured to provide a current detected from the AC voltage output of the the second convert unit to the master controller (11), and
wherein the cell controller (35) varies a frequency applied to the motor (20) to obtain a starting torque and controls a motor speed at the same time.

2. The multilevel inverter of claim 1, wherein each of the two current sensors (34-1, 34-2) is a voltage type current sensor.

## Patentansprüche

1. Mehrstufiger Wechselrichter (10), der konfiguriert ist, um eine 3-phasige Spannung an einen Motor (20) auszugeben,
der mehrstufige Wechselrichter beinhaltend:
eine Vielzahl von seriell verbundenen Einheitenleistungszellen (12), die eine Phase bilden,
**dadurch gekennzeichnet, dass** jede der Einheitenleistungszellen zwei Stromsensoren (34-1, 34-2) umfasst, die konfiguriert sind, um einen Ausgangsstrom der jeweiligen Einheitenleistungszellen zu erfassen.
wobei jede der Einheitenleistungszellen (12) einen Gleichrichter (31), der konfiguriert ist, um eine eingegebene Wechselspannung auf eine Gleichspannung gleichzurichten, einen Zwischenkreiskondensator (32), der konfiguriert ist, um eine Ausgangsspannung des Gleichrichters zu glätten, eine Zellensteuerung (35), die konfiguriert ist, um ein PWM-Signal (Pulsbreitenmodulation) in Reaktion auf die von der Hauptsteuerung (11) empfangenen Spannungspegelinformationen zu erzeugen, eine Wechselrichtereinheit (33), die konfiguriert ist, um eine Gleichspannung des Zwischenkreiskondensators (32) in eine Wechselspannung umzuwandeln, die in Reaktion auf das PWM-Signal der Zellensteuerung (35) an den Motor (20) ausgegeben werden soll, und zwei Stromsensoren (34-1, 34-2), die konfiguriert sind, um einen Ausgangsstrom der Wechselrichtereinheit (33) zu erfassen, beinhaltet,
wobei die Wechselrichtereinheit (33) eine erste Umwandlungseinheit und eine zweite Umwandlungseinheit beinhaltet, wobei jede der ersten Umwandlungseinheit und die zweite Umwandlungseinheit zwei in Reihe geschaltete IGBTs (Insulated Gate Bipolar Transistors) beinhaltet, und die erste Umwandlungseinheit und die zweite Umwandlungseinheit parallel geschaltet sind,
wobei zwei Stromsensoren (34-1, 34-2) einen ersten Stromsensor (34-1) beinhalten, der konfiguriert ist, um einen Strom bereitzustellen, der von dem Wechselspannungsausgang der ersten Umwandlungseinheit an die Hauptsteuerung (11) erfasst wird, und einen zweiten Stromsensor (34-2), der konfiguriert ist, um einen Strom bereitzustellen, der von dem Wechselspannungsausgang der zweiten Umwandlungseinheit an die Hauptsteuerung (11) erfasst wird, und
wobei die Zellensteuerung (35) eine auf den Motor (20) angelegte Frequenz variiert, um ein Anlaufmoment zu erhalten, und gleichzeitig eine Motordrehzahl steuert.

2. Mehrstufiger Wechselrichter nach Anspruch 1, wobei jeder der beiden Stromsensoren (34-1, 34-2) ein spannungsabhängiger Stromsensor ist.

## Revendications

1. Onduleur multi-niveaux (10) configuré pour délivrer en sortie une tension triphasée à un moteur (20), l'onduleur multi-niveaux comprenant une pluralité de cellules d'énergie unitaires connectées en série (12) formant une phase, **caractérisé en ce que** chacune des cellules d'énergie unitaires comprend deux capteurs de courant (34-1, 34-2) configurés pour détecter un courant de sortie de chacune desdites cellules d'énergie unitaires.
dans lequel chacune desdites cellules d'énergie unitaires (12) comprend un redresseur (31) configuré pour redresser une tension CA entrée en une tension CC, un condensateur de liaison CC (32) configuré pour lisser une tension de sortie du redresseur, un dispositif de commande de cellule (35) configuré pour générer un signal MLI (modulation d'impulsions en largeur) en réponse aux informations de niveau de tension reçues depuis le dispositif de commande maître (11), une unité d'onduleur (33) configurée pour convertir une tension CC du condensateur de liaison CC (32) en une tension CA à délivrer en sortie au moteur (20) en réponse au signal MLI du dispositif de commande de cellule (35), et deux capteurs de courant (34-1, 34-2) configurés pour détecter un courant de sortie de l'unité d'onduleur (33).
dans lequel l'unité d'onduleur (33) comprend une première unité de conversion et une seconde unité de conversion, chacune de la première unité de conversion et de la seconde unité de conversion comprenant deux IGBT (transistors bipolaires à grille isolée) connectés en série, et la première unité de conversion et la seconde unité de conversion sont connectées en parallèle,
dans lequel les deux capteurs de courant (34-1, 34-2) comprennent un premier capteur de courant (34-1) configuré pour fournir un courant détecté de la sortie de tension CA de la première unité de conversion au dispositif de commande maître (11), et un second capteur de courant (34-2) configuré pour fournir un courant détecté de la sortie de tension CA de la seconde unité de conversion au dispositif de commande maître (11), et
dans lequel le dispositif de commande de cellule (35) fait varier une fréquence appliquée au moteur (20) pour obtenir un couple de démarrage et commande une vitesse de moteur en même temps.

2. Onduleur multi-niveaux selon la revendication 1, dans lequel chacun des deux capteurs de courant (34-1, 34-2) est un capteur de courant de type tension.
